# EUROPEAN PATENT APPLICATION

(11) **EP 2 067 812 A1**
(43) Date of publication of application: **10.06.2009**
(21) Application number: 07828730.7
(22) Date of filing: 28.09.2007
(51) Int. Cl.: C08J 5/08, B32B 17/10

(54) **MOLDED OBJECT, PROCESS FOR PRODUCING THE SAME, AND CROSSLINKED MOLDING AND COPPER-CLAD LAMINATE EACH OBTAINED FROM THE SAME**

(30) Priority: 29.09.2006 JP 2006267130
(71) Applicant: Zeon Corporation, Tokyo 100-8246 (JP)
(72) Inventor: TANIMOTO, Hirotoshi, Tokyo 100-8246 (JP); SUGAWARA, Tomoo, Tokyo 100-8246 (JP); KODEMURA, Junji, Tokyo 100-8246 (JP)
(74) Representative: Vossius & Partner
(86) International application number: PCT/JP2007/068989
(87) International publication number: WO 2008/038772

(57) **Abstract**

The present invention intends to provide a crosslinkable molded article and a crosslinked molded article free from molding failures, wherein their coefficient of thermal expansion is sufficiently low, their dimensional accuracy is high and a polymerizable composition is sufficiently filled in a fibrous material; a process for producing the same; and a use of such molded articles.

A process for producing the molded articles of the present invention is **characterized by** producing a crosslinkable molded article by performing ring-opening bulk polymerization of a polymerizable composition comprising a cycloolefin monomer, a metathesis catalyst and, in accordance with need, a crosslinking agent and/or a filler in the presence of a glass yarn cloth having a bulk density of 0.50 to 1.10 g/cm³ and, then, if desired, conducting a crosslinking reaction.

## Description

### TECHNICAL FIELD

The present invention relates to a molded article obtained by performing ring-opening bulk polymerization of a cycloolefin monomer, more particularly, relates to a molded article, which has a low coefficient of thermal expansion and no molding failure, obtained by performing ring-opening bulk polymerization of a cycloolefin monomer; a process for producing the same; and a crosslinked molded article and a copper-clad laminate each obtained by using the molded article.

### BACKGOUND ART

By performing ring-opening bulk polymerization of a polymerizable composition containing a cycloolefin monomer and a metathesis catalyst, it is possible to obtain molded articles having a variety of shapes with simple-structured molds. Regarding such molded articles, it has been demanded to obtain a molded article having improved various characteristics, by lowering the coefficient of thermal expansion, heightening the dimensional accuracy, improving the mechanical strength and flame retardancy, etc. As a method therefor, there have been proposed a method of obtaining a molded article by arranging a fibrous material in a mold, etc. in advance and compounding the fibrous material in the molded article and a method of obtaining a molded article by using a polymerizable composition containing a filler.

For example, the Patent Article 1 discloses a method of obtaining a fiber-reinforced molded article by performing ring-opening bulk polymerization of a polymerizable composition containing a cycloolefin monomer and a metathesis catalyst in the presence of long glass fibers. The Patent Article 2 discloses a method of obtaining a molded article having improved flame retardancy by performing ring-opening bulk polymerization of a polymerizable composition containing a cycloolefin monomer, a metathesis catalyst and red phosphorus particles having an average particle diameter of 0.5 to 20µm in the presence of long glass fibers.

[Patent Article 1] The Japanese Unexamined Patent Publication No. H01-263124 (corresponding to EP Publication No. 0338128)
[Patent Article 2] The Japanese Unexamined Patent Publication No. H09-221551

### Technical Problem

As the results of study by the present inventors, however, they found that a molded article obtained by the conventional methods as explained above and a crosslinked molded article obtained by crosslinking the same had such disadvantages that the coefficient of thermal expansion was not sufficiently low to decline the dimensional accuracy or the polymerizable composition was not sufficiently filled in the fibrous material, so that voids were generated to thereby easily cause molding failures. An object of the present invention is to provide a molded article having a sufficiently low coefficient of thermal expansion and high dimensional accuracy, wherein a polymerizable composition is sufficiently filled in a fibrous material, so that the molded article is free from molding failures; a process for producing the same and a use of the molded articles.

### Solution to Problem

As a result of intensive study by the inventors to attain the above objects, they found that, although a glass yarn cloth is suitable as a fibrous material, a glass yarn cloth which has been conventionally used in the ring-opening bulk polymerization of a cycloolefin monomer had a too high bulk density and found that it was suitable to use those having a bulk density in a specific range.

Thus, according to the present invention, there is provided a process for producing a molded article, wherein a polymerizable composition containing a cycloolefin monomer and a metathesis catalyst is subjected to ring-opening bulk polymerization in the presence of a glass yarn cloth having a bulk density of 0.50 to 1.10 g/cm³.

Preferably, the polymerizable composition furthermore contains a filler, a crosslinking agent, or both of the two. As an embodiment of the production process, a process for producing the molded article by arranging the glass yarn cloth on a support body and, in a state where a polymerizable composition exists inside and both outer surfaces of the glass yarn cloth, performing the ring-opening bulk polymerization may be mentioned. As another embodiment, a process for producing the molded article by arranging the glass yarn cloth in a mold and, in a state where the polymerizable composition exists inside the glass yarn cloth and between the glass yarn cloth and the mold, performing the ring-opening bulk polymerization may be mentioned.

Alternately, a crosslinkable molded article can be obtained by arranging the glass yarn cloth on a support body and, in a state where the polymerizable composition containing a crosslinking agent exists inside and both outer surfaces of the glass yarn cloth, performing the ring-opening bulk polymerization. Preferably, the polymerizable composition in this case contains a filler. By heating the molded article to a higher temperature than a peak temperature of the ring-opening bulk polymerization to crosslink the molded article, a crosslinked molded article can be obtained. At that time, by stacking the crosslinkable molded article and a substrate material, and conducting crosslinking of the molded article to obtain a crosslinked molded article, a composite material composed of the substrate material and the crosslinked molded article can be obtained. Particularly, when the substrate material is a copper foil, a copper-clad laminate can be obtained as a composite material.

### Advantageous Effects of the Invention

According to the present invention, a molded article or a crosslinked molded article having a sufficiently low coefficient of thermal expansion and high dimensional accuracy, wherein a polymerizable composition is sufficiently filled in a fibrous material, so that the molded article or crosslinked molded article are free from molding failures; a process for producing the same and a use of the molded articles are provided.

### BEST MODE FOR CARRYING OUT THE INVENTION

### <Polymerizable Composition>

In the present invention, a composition containing as its essential components a cycloolefin monomer and a metathesis catalyst is referred to as a polymerizable composition.

A cycloolefin monomer indicates a monomer (a metathesis ring-opening polymerizable compound) having an alicyclic structure (a ring structure consisting of carbon atoms). As a cycloolefin monomer, a norbornene monomer is preferable. A norbornene monomer here indicates a monomer having a norbornene ring of an alicyclic structure. Examples of norbornene monomers may be mentioned by classifying them based on the number of rings of the ring structure including the norbornene ring as a part thereof. A bicyclic norbornene monomer can be obtained by an addition reaction of cyclopentadiene and unsaturated chain hydrocarbon, and norbornene and a substitution product thereof, etc. may be mentioned. A tricyclic norbornene monomer can be obtained by an addition reaction of cyclopentadiene and unsaturated hydrocarbon having a ring structure, and dicyclopentadiene as a dimer of cyclopentadiene and a substitution product thereof, etc. may be mentioned. A tetracyclic norbornene monomer can be obtained by an addition reaction of cyclopentadiene and bicyclic norbornene monomer, and tetracyclododecene and a substitution product thereof, etc. may be mentioned. A pentacyclic norbornene monomer can be obtained by an addition reaction of cyclopentadiene and a tricyclic norbornene monomer, and a trimer of cyclopentadiene and a substitution product thereof, etc. may be mentioned. A hexacyclic monomer or higher polycyclic monomers can be also obtained by an addition reaction of the same sort and may be used as a norbornene monomer of the present invention. Here, the substitution products may be the respective norbornene monomers substituted by a hydrocarbon group, such as an alkyl substitution product, alkenyl substitution product, alkylidene substitution product, aryl substitution product and the like; and substitution products wherein a part of the hydrocarbon group is substituted by a polar group, such as a halogen atom, and a carbonyloxyalkyl group.

As specific examples of norbornene and a substitution product thereof, 2-norbornene, 5-methyl-2-norbornene, 5-ethyl-2-norbornene, 5-hexyl-2-norbornene, 5-cyclohexyl-2-norbornene, 5-ethylidene-2-norbornene, 5-vinyl-2-norbornene, 5-phenyl-2-norbornene, 7-oxa-2-norbornene, 5-methyl-7-oxa-2-norbornene, 7-oxa-5-norbornene-2-yl acetate and 7-oxa-5-norbornene-2-yl methacrylate, etc. may be mentioned. As specific examples of dicyclopentadiene and a substitution product thereof, dicyclopentadiene, methyldicyclopentadiene and dihydrodicyclopentadiene (also referred to as tricyclo[5.2.1.0^{2,6}]deca-8-ene), etc. may be mentioned. As specific examples of tetracyclododecene and a substitution product thereof, tetracyclododecene (also referred to as tetracyclo[6.2.1.1^{3,6}.0^{2,7}]dodeca-4-ene), 9-methyltetracyclo[6.2.1.1^{3,6}0^{2,7}]odeca-4-ene, 9-ethyltetracyclo[6.2.1.1^{3,6}0^{2,7}]dodeca-4-ene, 9-cyclohexyltetracyclo[6.2.1.1^{3,6}0^{2,7}]dodeca-4-ene, 9-cyclopentyltetracyclo[6.2.1.1^{3,6}0^{2,7}]dodeca-4-ene, 9-ethylidenetetracyclo[6.2.1.1^{3,6}0^{2,7}]dodeca-4-ene, 9-vinyltetracyclo[6.2.1.1^{3,6}0^{2,7}]dodeca-4-ene, 9-phenyltetracyclo[6.2.1.1^{3,6}0^{2,7}]dodeca-4-ene, 9-oxycarbonylmethyl[6.2.1.1^{3,6}0^{2,7}]dodeca-4-ene, 9-methyl-9-oxycarbonylmethyl-tetracyclo[6.2.1.1^{3,6}0^{2,7}]dodeca-5-ene, 9-methoxy-tetracyclo[6.2.1.1^{3,6}0^{2,7}]dodeca-4-ene, 4-hydroxy-tetracyclo[6.2.1.1^{3,6}0^{2,7}]dodeca-4-ene, 9-carboxy-tetracyclo[6.2.1.1^{3,6}0^{2,7}]dodeca-4-ene, 9,10-dicarboxy-tetracyclo[6.2.1.1^{3,6}0^{2,7}]dodeca-4-ene, tetracyclo[6.2.1.1^{3,6}0^{2,7}]dodeca-4-ene-9,10-dicarboxylic anhydride, 9-carbonitrile-tetracyclo[6.2.1.1^{3,6}0^{2,7}]dodeca-4-ene, tetracyclo[6.2.1.1^{3,6}0^{2,7}]dodeca-4-ene-9-carbaldehyde, tetracyclo[6.2.1.1^{3,6}0^{2,7}]dodeca-4-ene-9-carboxamide, tetracyclo[6.2.1.1^{3,6}0^{2,7}]dodeca-4-ene-9,10-dicarboxylic imide, 9-chlorotetracyclo[6.2.1.1^{3,6}0^{2,7}]dodeca-4-ene, 4-trimethoxysilyltetracyclo[6.2.1.1^{3,6}0^{2,7}]dodeca-9-ene and 9-acetyltetracyclo[6.2.1.1^{3,6}0^{2,7}]dodeca-4-ene, etc. may be mentioned. As other tetracyclic or higher polycyclic norbornene monomers, tetracyclo[9.2.1.0^{2,10}.0^{3,8}]tetradeca-3,5,7,12-tetraene (also referred to as 1,4-methano-1,4,4a,9a-tetrahydro-9H-fluorene), tetracyclo[10.2.1.0^{2,11}.0^{4,9}]pentadeca-4,6,8,13-tetraene (also referred to as 1,4-methano-1,4,4a,9,9a,10-hexahydroanthracene), pentacyclo[6.5.1.1^{3,6}0^{2,7}.0^{9,13}]pentadeca-4,10-diene, pentacyclo[9.2.1.1^{4,7}.0^{2,10}.0^{3,8}]pentadeca-5,12-diene and hexacyclo[6.6.1.1^{3,6}.1^{10,13}.0^{2,7}.0^{9,14}]heptadeca-4-ene, etc. may be mentioned.

Also, as other cycloolefin monomers, cyclobutene, cyclopentene, cyclooctene, cyclododecene, 1,5-cyclooctadiene and other monocyclic cycloolefin, and derivatives of the same having a substituent group may be mentioned. These monomers may be used in combination with the norbornene monomers explained above. An additive amount of the monocyclic cycloolefins and derivatives thereof is preferably 40 wt% or smaller and, more preferably, 20 wt% or smaller with respect to the total amount of the cycloolefin monomer. When the additive amount exceeds the range, the resulting molded article and crosslinked molded article may become too soft at the normal temperature or the heat resistance becomes poor in some cases, which is unfavorable.

These cycloolefin monomers may be used alone or in combination of two or more kinds. By using two or more kinds of cycloolefin monomers and changing the amount ratio, a glass transition temperature, melting temperature and heat resistance of the resulting molded article and crosslinked molded article can be freely controlled.

In the present invention, a metathesis catalyst is used in ring-opening bulk polymerization of a cycloolefin monomer. The metathesis catalyst is not particularly limited as far as being able to ring-opening polymerize a cycloolefin monomer. A metathesis catalyst is a complex in which a plurality of ions, atoms, polyatomic ions and/or compounds bond to a transition metal atom as the central atom. As the transition metal atom, group 5, group 6 and group 8 (the long period-type periodic table: the same in the explanations below) atoms are used. Atoms of each group are not particularly limited and, for example, tantalum may be mentioned as a group 5 atom, molybdenum and tungsten may be mentioned as a group 6 atom and, ruthenium and osmium may be mentioned as a group 8 atom.

As a metathesis catalyst containing tungsten or molybdenum of group 6 atom as the center metal, metal halides such as tungsten hexachloride; metal oxyhalides such as tungsten chlorine oxide; metal oxides such as tungsten oxide; and organometallic acid ammonium salts such as tridodecyl ammonium molybdate and tri(tridecyl) ammonium molybdate, etc. may be used. Among them, ammonium organomolybdate salts are preferable. When using the above metathesis catalysts are used, it is preferable to use them in combination with an organoalminium compound or an organotin compound as an activator (cocatalyst) for the purpose of controlling polymerization activity.

In the present invention, as a metathesis catalyst, it is also preferable to use a metal carbene complex containing a group 5, 6 or 8 metal atom as the central atom. Among metal carbene complexes, carbene complexes of ruthenium or osmium as group 8 atom are preferable, and a ruthenium carbene complex is particularly preferable. It is because the activity of the catalyst is excellent in ring-opening bulk polymerization to effectively produce molded articles, and an odor (derived from an unreacted cycloolefin monomer) of an obtained molded article and crosslinked molded article is little, whereby their productivity is excellent. In a metal carbene complex, the central metal atom bonds with a carbene compound, so that the complex has a structure (M=C) that a metal atom (M) and a carbene carbon (>C:) are directly bonded. The carbene compound is a generic name of compounds having a carbene carbon, that is, a methylene free radical. Among ruthenium carbene complexes, a ruthenium carbene complex, wherein a hetero atom-containing carbene compound is bonded as a ligand, is particularly preferable. Here, a hetero atom indicates a group 15 and 16 atom and, specifically, N, O, P, S, As and Se atoms may be mentioned. Among them, N, O, P and S atoms are preferable and an N atom is particularly preferable in view of the capability of obtaining a stable carbene compound. Among hetero atom-containing carbene compounds, those wherein hetero atoms are adjacent to and bonded with a carbene carbon preferably on both sides of the carbene carbon are preferable, and those containing a hetero ring including a carbene carbon atom and hetero atoms on both sides of the carbene carbon are more preferable. Furthermore preferably, the hetero atoms adjacent to a carbene carbon have a bulky substituent. When a ruthenium carbene complex, in which a carbene compound having the above preferable structure is bonded, is used as a metathesis catalyst, activity of ring-opening bulk polymerization becomes particularly high and the production efficiency of a molded article and crosslinked molded article becomes particularly high. Specific examples of a ruthenium carbene complex are disclosed in WO97/06185, Published Japanese Translation of PCT International Publication for Patent Application No. 10-508891 and the Japanese Unexamined Patent Publication No. H11-322953 etc.

As compounds preferably used as a ruthenium carbene complex, benzylidene(1,3-dimesitylimidazolidine-2-ylidene)(tricyclohexylphosphine)ruthenium dichloride, benzylidene(1,3-dimesityl-4,5-dibromo-4-imidazoline-2-ylidene)(tricyclohexylphosphine)ruthenium dichloride, (1,3-dimesityl-4-imidazoline-2-ylidine)(3-phenyl-1H-indene-1-ylidene)(tricyclohexylphosphine)ruthenium dichloride, (3-butenylidene-2-pyridine)(1,3-dimesityl-4-imidazoline-2-ylidene)(tricyclohexylphosphine)ruthenium dichloride, benzylidene(1,3-dimesitylimidazolidine-2-ylidene)pyridineruthenium dichloride, (1,3-dimesitylimidazolidine-2-ylidene)(2-phenylethylidene)(tricyclohexylphosphine)ruthenium dichloride, (1,3-dimesityl-4-imidazoline-2-ylidene)(2-phenylethylidene)(tricyclohexylphosphine)ruthenium dichloride, (1,3-dimesityl-4,5-dibromo-4-imidazoline-2-ylidene)[(phenylthio)methylene](tricyclohexylphosphine)ru thenium dichloride and (1,3-dimesityl-4,5-dibromo-4-imidazoline-2-ylidene)(2-pyrolidone-1-ylmethylene)(tricyclohexylphosphine)ruthenium dichloride, etc. may be mentioned.

A usage of the metathesis catalyst in the molar ratio of (metal atoms in the catalyst : cycloolefin monomer) is normally in a range of 1:2,000 to 1:2,000,000, preferably 1:5,000 to 1:1,000,000, and more preferably 1:10,000 to 1:500,000.

A metathesis catalyst may be dissolved or suspended in a small amount of an inert solvent on its use in accordance with need. As the solvent as such, for example, linear aliphatic hydrocarbons such as n-pentane, n-hexane, n-heptane, liquid paraffin and mineral spirit; alicyclic hydrocarbons such as cyclopentane, cyclohexane, methylcyclohexane and ethylcyclohexane; aromatic hydrocarbons such as benzene, toluene and xylene; hydrocarbons having a condensed ring of an aromatic ring and alicyclic ring such as indene, indane and tetrahydronaphthalene; nitrogen-containing hydrocarbons such as nitromethane, nitrobenzene and acetonitrile; oxygen-containing hydrocarbons such as diethyl ether and tetrahydrofurane; etc. may be mentioned. Among them, industrially, hydrocarbon is preferably used. Also, as far as it does not deteriorate activity of the metathesis polymerization catalyst, liquid antioxidants, liquid plasticizers and liquid elastomers may be used as a solvent.

It is preferable that a polymerizable composition further contains filler. The filler is solids insoluble in a polymerizable composition and includes a flame retardant agent and a pigment for coloring in addition to components used as so-called "fillers" in general production of a molded article. As a usable filler in the present invention, for example, inorganic fillers such as a glass powder, carbon black, silica, talc, calcium carbonate, mica, alumina, titanium dioxide, zirconia, mullite, cordierite, magnesia, clay and barium sulfate; and organic fillers such as wood powder and polyethylene powder may be mentioned. A graphite powder, charcoal powder, bamboo coal powder, metal powder, etc. may be also used as the filler and, they can improve conductivity and electromagnetic wave shielding property of a molded article and crosslinked molded article. Powders of barium titanate, strontium titanate, lead titanate, magnesium titanate, bismuth titanate, lead zirconate, etc. may be also used and, they can enhance a dielectric constant of a molded article and crosslinked molded article. Ferromagnetic metal powders or the like of ferrites of Mn-Mg-Zn base, Ni-Zn base, Mn-Zn base, etc.; and carbonyl iron, iron-silicon based alloys, iron-aluminum-silicon based alloys and iron-nickel based alloys; may be also used and, they can give a ferromagnetic property to the molded article and crosslinked molded article. As a flame retardant, phosphorus-based flame retardants, nitrogen-based flame retardants, halogen-based flame retardants and metal hydroxide-based flame retardants such as aluminum hydroxide or the like may be mentioned. Those flame retardants may be used alone but preferably used in combination of two or more kinds. As a pigment, for example, carbon black, graphite, chrome yellow, iron oxide yellow, titanium dioxide, zinc oxide, trilead tetraoxide, minium, chromic oxide, iron blue and titanium black, etc. may be mentioned. Among those fillers, inorganic fillers are preferable and silica is particularly preferable in terms of excellent electric properties of an obtained molded article and crosslinked molded article. As to a shape of the fillers, those having a small average particle diameter are preferable and a sphere shape is preferable because fluidity of an obtained polymerizable composition becomes excellent. Examples of preferable fillers are available on markets under the name of fine powdery spherical silica or synthetic spherical silica.

Optionally, a surface treatment with a surface treatment agent may be performed in advance on these fillers before blending them in a polymerizable composition. In that case, general silane coupling agent treatment is applicable. The silane coupling agent to be used is normally expressed by the general formula (1).

Y¹ₙSiY²₄₋ₙ (1)

Here, Y¹ is a monovalent group having a functional group and bonded to Si and, Y² is a monovalent group having a hydrolyzable property and bonded to Si. "n" indicates an integer from 1 to 3 and is preferably 1. As the above functional group Y¹, saturated linear hydrocarbon groups such as hexyl group; saturated cyclic hydrocarbon groups such as cyclohexyl group; aromatic hydrocarbon groups such as phenyl group; unsaturated hydrocarbon groups such as vinyl group, allyl group, butenyl group, octenyl group and styryl group; hydrocarbon groups including nitrogen atom, oxygen atom or sulfur atom such as amino group, epoxy group, mercapto group, methacryloxy group, cyano group, carbamate group, pyridyl group, sulfonylazide group, carbamide group, ammonium group and alcohol group; may be mentioned. Among them, saturated linear hydrocarbon groups, saturated cyclic hydrocarbon groups, aromatic hydrocarbon groups and unsaturated hydrocarbon groups are preferable to reduce the coefficient of thermal expansion of the resulting molded article. As the hydrolyzable group Y², for example, halogen such as chlorine and bromine; and alkoxy group such as methoxy, ethoxy and methoxyethoxy may be mentioned. As the surface treatment method, a dry method and a wet method may be mentioned. A dry method is a method of treating a filler by uniformly dispersing a surface treatment agent stock solution or solution to the filler being subjected to high speed agitation by an agitator; which is generally used in industry. An amount of the surface treatment agent is normally 0.01 to 10 wt%, preferably, 0.1 to 5 wt% with respect to the filler. In a wet method, the surface treatment is performed by dissolving a surface treatment agent normally in water or in a suitable solvent to use it as a treatment solution, immersing surfaces of powders, grains or fibers of the filler in the treatment solution and, then, drying away the used water or solvent. Concentration of the treatment solution is normally 0.001 to 10 wt%, and the drying conditions are normally 0 to 200°C for 10 seconds to 5 hours.

These fillers may be used alone or in combination of two or more. A usage of the fillers is normally 1 to 500 parts by weight, preferably 10 to 400 parts by weight, more preferably 30 to 300 parts by weight, and furthermore preferably 50 to 200 parts by weight with respect to 100 parts by weight of a cycloolefin monomer. It is preferable because when the usage is in these ranges, the flow property and impregnating property of the polymerizable composition are preferable, and an obtained molded article or crosslinked molded article have a low coefficient of thermal expansion and an excellent dimensional accuracy. An average particle diameter of the filler is normally 0.001µm to 10µm, preferably 0.01µm to 1µm, particularly preferably 0.02µm to 0.5µm, and furthermore preferably 0.03µm to 0.2µm. When the average particle diameter is in these ranges, the flow property and impregnating property of the polymerizable composition are preferable, and an obtained molded article or crosslinked molded article have an excellent dimensional accuracy. A filler having an average particle diameter of being out of the above ranges may be used together within a range of not hindering the objects of the present invention, however, the usage range is normally 10 parts by weight or less, preferably 5 parts by weight or less and particularly preferably 1 part by weight or less. Here, the average particle diameter is a volume average particle diameter measured by a laser diffraction method.

It is preferable that the polymerizable composition furthermore includes a chain transfer agent. By performing ring-opening bulk polymerization in the presence of a linear transfer agent, a thermoplastic molded article can be obtained. As a chain transfer agent, for example, chain olefins which can include a substituent group may be used. As specific examples thereof, for example, aliphatic olefins such as 1-hexene and 2-hexene; olefins having an aromatic group such as styrene, divinylbenzene and stilbene; olefins having an aliphatic hydrocarbon group such as vinylcyclohexane; vinyl ethers such as ethylvinyl ether; vinylketones such as methylvinylketone, 1,5-hexadiene-3-one and 2-methyl-1,5-hexadiene-3-on and compounds expressed by a general formula of CH₂=CH-Q (in the formula, Q indicates a group having at least one group selected from a methacryloyl group, acryloyl group, vinylsilyl group, epoxy group and amino group); may be mentioned. Among these compounds, it is preferable to use a compound expressed by a general formula of CH₂=CH-Q, because Q is introduced to terminals of a ring-opening bulk polymer in a molded article, and Q at the terminals contributes to crosslinking in the later crosslinking step to increase the crosslink density. As specific examples of the compounds expressed by a general formula of CH₂=CH-Q, compounds in which Q is a group having methacryloyl group such as vinyl methacrylate, allyl methacrylate, 3-butene-1-yl methacrylate, 3-butene-2-yl methacrylate, stilyl methacrylate, hexenyl methacrylate, undecenyl methacrylate and decenyl methacrylate; compounds in which Q is a group having an acryloyl group such as allyl acrylate, 3-butene-1-yl acrylate, 3-butene-2-yl acrylate, 1-methyl-3-butene-2-yl acrylate, stilyl acrylate and ethylene glycol diacrylate; compounds in which Q is a group having a vinylsilyl group such as allyltrivinylsilane, allylmethyldivinylsilane and allyldimethylvinylsilane; compounds in which Q is a group having an epoxy group such as glycidyl acrylate and allylglycidyl ether; and compounds in which Q is a group having an amino group such as allylamine, 2-(diethylamino)ethanolvinyl ether, 2-(diethylamino)ethyl acrylate and 4-vinylaniline; etc. may be mentioned.

Usage of the chain transfer agent is normally 0.01 to 10 parts by weight and preferably 0.1 to 5 parts by weight with respect to 100 parts by weight of total cycloolefin monomers. When a usage of the chain transfer agent is in these ranges, polymerization reaction rate of ring-opening bulk polymerization is high and, moreover, a thermoplastic molded article which is crosslinkable in a later step can be obtained efficiently. When the usage of the chain transfer agent is too small, a molded article may not become thermoplastic in some cases. Conversely, when the usage is too great, crosslinking may become difficult in a later step in some cases.

Preferably, the polymerizable composition contains a crosslinking agent. A crosslinking agent induces a crosslinked structure through crosslinking reaction with a functional group in a molded article obtained from the ring-opening bulk polymerization. As a functional group to be involved in such a crosslinking reaction, for example, carbon-carbon double bond, a carboxylic acid group, acid anhydride group, hydroxyl group, amino group, active halogen atom and epoxy group, etc. may be mentioned; and, when a molded article has the functional group, an obtained molded article can be a crosslinkable molded article by adding a crosslinking agent to the polymerizable composition.

As a crosslinking agent, for example, a radical generator, epoxy compound, isocyanate group-containing compound, carboxyl group-containing compound, acid anhydride group-containing compound, amino group-containing compound and Lewis acid, etc. may be mentioned. These crosslinking agents may be used alone or in combination of two or more. Among them, a radical generator, epoxy compound, isocyanate group-containing compound, carboxyl group-containing compound and acid anhydride group-containing compound are preferable; use of a radical generator, epoxy compound and isocyanate group-containing compound is more preferable; and a radical generator is particularly preferable.

As a radical generator, for example, an organic peroxide, diazo compound, and nonpolar radical generator, etc. may be mentioned. As an organic peroxide, for example, hydroperxides such as t-butyl hydroperoxide, p-menthane hydroperoxide and cumene hydroperoxide; dialkyl peroxides such as dicumyl peroxide, t-butylcumyl peroxide, α,α'-bis(t-butylperoxy-m-isopropyl)benzene, di-t-butylperoxide, 2,5-dimethyl-2,5-di(t-butylperoxy)-3-hexine and 2,5-dimethyl-2,5-di(t-butylperoxy)hexane; diacyl peroxides such as dipropionyl peroxide and benzoil peroxide; peroxyketals such as 2,5-dimethyl-2,5-di(t-butylperoxy)hexane, 2,5-dimethyl-2,5-di(t-butylperoxy)hexine-3 and 1,3-di(t-butylperoxy isopropyl)benzene; peroxy esters such as t-butylperoxy acetate and t-butylperoxy benzoate; peroxycarbonates such as t-butylperoxy isopropyl carbonate and di(isopropylperoxy)dicarbonate; and alkylsilyl peroxide such as t-butyltrimethylsylil peroxide ; etc. may be mentioned. Among them, dialkyl peroxides are preferable for causing less hindrance in ring-opening bulk polymerization of a metathesis catalyst.

As a diazo compound, for example, 4,4'-bisazidobenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenyl sulfone, 4,4'-diazidodiphenylmethane and 2,2'-diazido stilbene, etc. may be mentioned.

As a nonpolar radical generator, 2,3-dimethyl-2,3-diphenylbutane, 2,3-diphenylbutane, 1,4-diphenylbutane, 3,4-dimethyl-3,4-diphenylhexane, 1,1,2,2-tetraphenylethane, 2,2,3,3-tetraphenylbutane, 3,3,4,4-tetraphenylhexane, 1,1,2-triphenylpropane, 1,1,2-triphenylethane, triphenylmethane, 1,1,1-triphenylethane, 1,1,1-triphenylpropane, 1,1,1-triphenylbutane, 1,1,1-triphenylpentane, 1,1,1-triphenyl-2-propene, 1,1,1-triphenyl-4-pentene and 1,1,1-triphenyl-2-phenylethane, etc. may be mentioned.

As an epoxy compound, compounds having two or more epoxy groups in the molecule, for example, glycidyl ether type epoxy compounds such as phenol novolak-based epoxy compound, cresol novolak-based epoxy compound, cresol-based epoxy compound, bisphenol A type epoxy compound, bisphenol F type epoxy compound, brominated bisphenol A type epoxy compound, brominated bisphenol F type epoxy compound and hydrogenated bisphenol A type epoxy compound; polyvalent epoxy compounds such as aliphatic epoxy compound, glycidyl ester type epoxy compound, glycidyl amine type epoxy compound and isocyanurate type epoxy compound; etc. may be mentioned. As an isocyanate group-containing compound, compounds having two or more isocyanate groups in the molecule, for example, paraphenylene diisocyanate, 2,6-toluene diisocyanate and hexamethylene diisocyanate, etc. may be mentioned. As a carboxyl group-containing compound, compounds having two or more carboxyl groups in the molecule, for example, fumaric acid, phthalic acid, maleic acid, trimellitic acid, hymic acid, terephthalic acid, isophthalic acid, adipic acid and sebacic acid, etc. may be mentioned. As acid anhydride group-containing compound, for example, maleic anhydride, phthalic anhydride, pyromellic anhydride, benzophenonetetracarboxylic anhydride, nadic acid anhydride, 1,2-cyclohexanedicarboxylic anhydride and maleic anhydride-modified polypropylene, etc. may be mentioned. As a Lewis acid, for example, silicon tetrachloride, hydrochloric acid, sulfuric acid, ferric chloride, aluminum chloride, stannic chloride and titanium tetrachloride, etc. may be mentioned. As an amino group-containing compound, compounds having two or more amino groups in the molecule, for example, aliphatic diamines such as trimethylhexamethylenediamine, ethylenediamine and 1,4-diaminobutane; aliphatic polyamines such as triethylenetetramine, pentaethylenehexamine and aminoethylethanolamine; and aromatic amines such as phenylenediamine, 4,4'-methylenedianiline and toluenediamine, diaminoditolylsulfone; etc. may be mentioned.

A crosslinking agent to be used may be selected depending on functional group (crosslink site) in a molded article to be crosslinked. For example, when crosslinking proceeds at a carbon-carbon double bond site, a radical generator is preferably used. Also, when a thermoplastic resin having a carboxyl group or an acid anhydride group is crosslinked, an epoxy compound may be used; when a thermoplastic resin having a hydroxyl group is crosslinked, a compound containing an isocyanate group may be used; and when a thermoplastic resin containing an epoxy group is crosslinked, a carboxyl group-containing compound or an acid anhydride group-containing compound may be used. Other than the above, when cationical crosslinking is desired, a Lewis acid may be used as the crosslinking agent.

An amount of a crosslinking agent is not particularly limited and may be suitably set in accordance with a kind of a crosslinking agent to be used. For example, when a radical generator is used as a crosslinking agent, a usage of the crosslinking agent is normally 0.1 to 10 parts by weight, and preferably 0.5 to 5 parts by weight with respect to 100 parts by weight of a cycloolefin monomer. Also, when an epoxy compound is used as a crosslinking agent, the usage is normally 1 to 100 parts by weight, and preferably 5 to 50 parts by weight with respect to 100 parts by weight of a cycloolefin monomer. When the additive amount of a crosslinking agent is excessively small, crosslinking may become insufficient and it is likely that a crosslinked molded article having a high crosslink density cannot be obtained. When the usage is too great, the crosslink effect may be saturated and it is likely that a crosslinkable molded article or crosslinked molded article having a desired property cannot be obtained.

Optionally, other additives than the above may be added to the polymerizable composition in accordance with need. As other additives, activators of a metathesis catalyst, retarders of a radical crosslinking reaction, crosslinking auxiliaries, antioxidants, modifiers, colorants other than a filler and light stabilizers, etc. may be mentioned.

An activator of a metathesis catalyst is added for the purpose of controlling the polymerization activity of the metathesis catalyst and improving a rate of the polymerization reaction. As such an activator, alkylated products, halides, alkoxylated products and aryloxylated products, etc. of metals, such as aluminum, scandium, stannum, titanium and zirconium, may be mentioned. As specific examples of an activator, trialkoxy aluminum, triphenoxy aluminum, dialkoxyalkyl aluminum, alkoxydialkyl aluminum, trialkyl aluminum, dialkoxy aluminum chloride, alkoxyalkyl aluminum chloride, dialkyl aluminum chloride, trialkoxy scandium, tetraalkoxy titanium, tetraalkoxy stannum and tetraalkoxy zirconium, etc. may be mentioned. A usage of the activator is, in a molar ratio of (metal atoms in the metathesis catalyst):(the activator), normally in a range of 1:0.05 to 1:100, preferably 1:0.2 to 1:20, and more preferably 1:0.5 to 1:10. When a complex of groups 5 and 6 transition metal atoms is used as the metathesis catalyst, it is preferable that both of the metathesis polymerization catalyst and the activator are dissolved in a monomer on their use, however, they may be suspended or dissolved in a small amount of solvent to use them as far as it is within a range of not deteriorating a property of a molded article.

When a radical generator as a crosslinking agent, preferably a radical crosslinking retarder is contained in the polymerizable composition. A radical crosslinking retarder is a compound having a radical capturing function and exhibits an effect of retarding a radical crosslinking reaction by a radical generator. By adding a radical crosslinking retarder to the polymerizable composition, fluidity in processing a molded article and preservation stability of the molded article can be improved. As a radical crosslinking retarder, for example, alkoxyphenols such as 4-methoxyphenol, 4-ethoxyphenol, 3-t-butyl-4-hydroxyanisol, 2-t-butyl-4-hydroxyanisol and 3,5-di-t-butyl-4-hydroxyanisol; hydroquinones such as hydroquinone, 2-methylhydroquinone, 2,5-dimethylhydroquinone, 2-t-butylhydroquinone, 2,5-di-t-butylhydroquinone, 2,5-di-t-amylhydroquinone, 2,5-bis(1,1-dimethylbutyl)hydroquinone and 2,5-bis(1,1,3,3-tetramethylbutyl)hydroquinone; catechols such as catechol, 4-t-butylcatechol and 3,5-di-t-butylcatechol; and benzoquinones such as benzoquinone, naphthoquinone and methylbenzoquinone; etc. may be mentioned. Among them, alkoxyphenols, catechols and benzoquinones are preferable, and alkoxyphenols are particularly preferable. An amount of a radical crosslinking retarder is normally 0.001 to 1 mole, and preferably 0.01 to 1 mole with respect to 1 mole of the radical generator.

When the polymerizable composition contains a crosslinking agent, a crosslinking auxiliary may be used in combination with a crosslinking agent to improve the crosslinking effect. As a crosslinking auxiliary, well known crosslinking auxiliaries, for example, dioxime compounds such as p-quinone dioxime; methacrylate compounds such as lauryl methacrylate and trimethylolpropane trimethacrylate; fumaric acid compounds such as diallylfumarate; phthalic acid compounds such as diallylphthalate; cyanuric acid compounds such as triallylcyanurate; and imide compounds such as maleimide; may be mentioned. Also, compounds having two or more isopropenyl groups, such as diisopropenylbenzene, triisopropenylbenzene and trimethallyl isocyanate, may be also preferably used. Usage of a crosslinking auxiliary is not particularly limited, but normally 0 to 100 parts by weight and preferably 0 to 50 parts by weight with respect to 100 parts by weight of a cycloolefin monomer.

As an antioxidant, for example, a variety of antioxidants for plastic and rubber such as hindered phenol-based, phosphorous-based and amine-based antioxidants may be mentioned. These antioxidants may be used alone but preferably used in combination of two or more kinds.

As a modifier of a molded article or crosslinked molded article, a variety of elastomers may be added to the polymerizable composition. As such an elastomer, for example, natural rubber, polybutadiene, polyisoprene, styrene-butadiene copolymer (SBR), styrene-butadienestyrene block copolymer (SBS), styrene-isoprene-styrene block copolymer (SIS), ethylene-propylene-diene terpolymer (EPDM), ethylene-vinyl acetate copolymer (EVA) and hydrides thereof, etc. may be mentioned.

As a colorant other than a filler, a variety of dye may be added to the polymerizable composition. As a light stabilizer, for example, benzotriazole-based ultraviolet absorbers, benzophenone-based ultraviolet absorbers, salicylate-based ultraviolet absorber, cyanoacrylate-based ultraviolet absorbers, oxanilide-based ultraviolet absorbers, hindered amine-based ultraviolet absorbers, and benzoate-based ultraviolet absorbers, etc. may be added to the polymerizable composition.

Usages of the crosslinking agents, modifiers, colorants other than a filler, and light stabilizers are normally 0.001 to 100 parts by weight with respect to 100 parts by weight of the cycloolefin monomer.

By mixing the respective components explained above, a polymerizable composition can be obtained. The mixing order and mixing method are not particularly limited, however, when a cycloolefin monomer and a metathesis catalyst are mixed, reaction of metathesis ring-opening bulk polymerization starts, therefore, it is necessary to use the polymarizable composition within a certain time after mixing the two. Respective necessary components may be added to a cycloolefin monomer at one time to obtain a polymerizable composition, however, it is preferable that components other than the metathesis catalyst are mixed in advance and, then, the metathesis catalyst is added and mixed to use the polymerizable composition promptly. To mix the components effectively for attaining good dispersibility of each component, it is also preferable to divide the cycloolefin monomer to several portions, add each of the components other than the cycloolefin monomer separately thereto and mix the whole together. As the mixing means, an collision mixer or a static mixer, etc. is preferably used.

### <Glass Yarn Cloth>

In the present invention, ring-opening bulk polymerization is performed on a polymerizable composition in the presence of a specific glass yarn cloth. The glass yarn cloth is prepared by weaving glass threads (which is called a glass yarn) made by twisting strands obtained by converging glass filaments each having a diameter of 1 to 10µm. A variety of glass yarn cloths are commercially supplied from Asahi Fiber Glass Co., Ltd. and Asahi Schewer Co., Ltd., etc. and available. A bulk density (d) of the glass yarn cloth used in the present invention is 0.50 to 1.10g/cm³, preferably 0.70 to 1.06g/cm³, more preferably 0.80 to 1.06g/cm³, particularly preferably 0.90 to 1.04g/cm³, and furthermore preferably 0.90 to 1.02g/cm³. Here, the bulk density is a density including void spaces of the glass yarn cloth and obtained by dividing a weight per a unit area (including void spaces) by the thickness. When the bulk density of the glass yarn cloth is in the above ranges, an excellent balance can be obtained that moldability of a molded article by the ring-opening bulk polymerization is preferable, and a coefficient of thermal expansion of the resulting molded article and crosslinked molded article is low and the dimensional accuracy is excellent. A thickness of the glass yarn cloth is normally 5 to 200µm, preferably 10 to 150µm, more preferably 10 to 100µm, and particularly preferably 20 to 80µm. When the thickness is thinner than the above ranges, strength of the obtained molded article becomes weak, while when thicker than the ranges, there is a possibility of leading to a problem that controlling of the thickness at the time of stacking becomes difficult.

### <Ring-Opening Bulk Polymerization, Molded article and Crosslinked molded article>

By performing ring-opening bulk polymerization of the polymerizable composition in the presence of a specific glass yarn cloth, a molded article is obtained. The polymerizable composition is subjected to ring-opening bulk polymerization while opening the upper portion on a support body and being pressed on the upper portion on the support body by using other member or while being in a mold. Here, "in the presence of" means
(a) a state where the glass yarn cloth is arranged on the support body and the polymerizable composition exists inside and both outer surfaces of the glass yarn cloth, or
(b) a state where the glass yarn cloth is arranged in a mold and the polymerizable composition exists inside the glass yarn cloth and between the glass yarn cloth and the mold.
A shape of a molded article and crosslinked molded article obtained in the present invention is preferably plate-shaped, the support body and the other member are preferably plate-shaped, and the mold preferably has a suitable shape for molding a plate-shaped molded article. "Arrange" means to place a glass yarn cloth in parallel with a plane portion of the support body or an inner surface (a surface to contact with the polymerizable composition) of the mold. The glass yarn cloth may be one but it is also possible to use the glass yarn cloth by stacking two or more cloths.

A process for producing a molded article through the state (a) above will be explained. The specific method, for example: comprises
applying or pouring a polymerizable composition on a support body;
arranging a glass yarn cloth thereon and, in accordance with need, repeating an operation of applying or pouring the polymerizable composition thereon and arranging another glass yarn cloth in accordance with need for a desired number of times;
furthermore putting the other member on top thereof in accordance with need; and
performing the ring-opening bulk polymerization in this state.

Another specific producing process, comprises arranging a glass yarn cloth impregnated with a polymerizable composition on a support body and, in accordance with need, repeating this operation for a desired number of times;
furthermore putting the other member on top thereof in accordance with need; and
performing the ring-opening bulk polymerization in this state.

According to these processes, a film or plate-shaped molded article is obtained. As the support body and the other member to be used here, for example, polyethylene terephthalate, polypropylene, polyethylene, polycarbonate, polyethylene naphthalate, polyarylate, nylon and other resins; iron, stainless, copper, aluminum, nickel, chrome, gold, silver and other metal materials; etc. may be mentioned. A shape thereof is not particularly limited, however, use of a metal foil or a resin film is preferable. A thickness of the metal foil or resin film is normally 1 to 150µm, preferably 2 to 100µm, and more preferably 3 to 75µm in view of workability.

An applying method of the polymerizable composition on the support body surface is not particularly limited and well-known methods, such as a spray coat method, dip coat method, roll coat method, curtain coat method, dye coat method and slit coat method, may be mentioned. Impregnation of a polymerizable composition in the glass yarn cloth may be attained, for example, by applying a predetermined amount of the polymerizable composition to a fibrous material by a well known method, such as a spray coat method, dip coat method, roll coat method, curtain coat method, dye coat method and slit coat method; putting the other member on top thereof in accordance with need; and pressing by a roller, etc. from above. The polymerizable composition starts ring-opening bulk polymerization even only by preparing it by mixing the components, however, it is preferable to heat the polymerizable composition because the ring-opening bulk polymerization can be performed efficiently with a high reaction rate. A method of heating the polymerizable composition to a predetermined temperature is not particularly limited and a method of placing the support body on a heat plate and heating, a method of using a pressing machine to heat while pressurizing (hot press), a method of pressurizing with a heated roller and a method of using a heating furnace, etc. may be mentioned. A molded article to be obtained this way preferably has a film or plate shape, and has a thickness of normally 15mm or thinner, preferably 10mm or thinner, more preferably 5mm or thinner and particularly preferably 1mm or thinner. According to this method, a prepreg impregnated with a thermoplastic resin can be obtained as a molded article.

A process for producing a molded article through the state (b) above will be explained. Here, a conventionally known mold, for example, a mold having a splitting structure of a female mold and a male mold may be used, and a polymerizable composition is filled in their cavities to perform ring-opening bulk polymerization. The female mold and the male mold are formed to have a shape according to a desired shape of a molded article. A shape, material and size of the molds are not particularly limited. Alternately, by preparing a plate-shaped mold, such as a glass plate and a metal plate, and a spacer having a predetermined thickness and filling a reaction liquid in a space formed by sandwiching the spacer with two molds to perform ring-opening bulk polymerization, a plate-shaped or film-shaped molded article can be obtained. A filling pressure (injection pressure) at the time of filling the polymerizable composition in a cavity of a mold is normally 0.01 to 10 MPa and preferably 0.02 to 5 MPa. When the filling pressure is too low, it is likely that a transfer face formed on the cavity inner circumferential surface cannot be transferred well, while when the filling pressure is too high, rigidity of the mold has to be high which is not economical. A mold clamping pressure is normally in a range of 0.01 to 10 MPa. In this method also it is preferable to heat the polymerizable composition by heating the mold. According to this method, a molded article made of a thermoplastic resin having any shape can be obtained. As a shape thereof, a sheet shape, a film shape, columnar shape, cylindrical shape and polygonal columnar shape, etc. may be mentioned.

The temperature in the case of heating during the ring-opening bulk polymerization is normally 50 to 200°C and preferably 100 to 200°C. The reaction time of the ring-opening bulk polymerization may be suitably selected, but is normally 10 seconds to 20 minutes and preferably within 5 minutes. By heating the polymerizable composition to a predetermined temperature, the ring-opening bulk polymerization reaction starts. This reaction is an exothermic reaction, and once the ring-opening bulk polymerization starts, the temperature of the reaction liquid rapidly rises to reach the peak temperature in a short time (for example, 10 seconds to 5 minutes or so). When the polymerizable composition contains a crosslinking agent, if the highest temperature at the reaction becomes excessively high, the crosslinking reaction as well as the ring-opening bulk polymerization proceeds, as a result, there is a possibility that a crosslinkable molded article capable of crosslinking in a later process cannot be obtained. Therefore, to completely carry out the ring-opening bulk polymerization reaction alone and not to carry out the crosslinking reaction, it is necessary to control the peak temperature of the ring-opening bulk polymerization to normally lower than 230°C preferably lower than 200°C.

In the present invention, because the ring-opening polymerization is performed by using a metathesis catalyst without diluting the cycloolefin monomer with a solvent (bulk polymerization), it is called ring-opening bulk polymerization. A polymer obtained by performing the ring-opening bulk polymerization of a polymerizable composition in the presence of the glass yarn cloth is called a molded article in the present invention, and when the polymerizable composition contains a crosslinking agent, the obtained molded article is called a crosslinkable molded article. By heating the crosslinkable molded article after the ring-opening bulk polymerization, a crosslinking reaction can be conducted inside the crosslinkable molded article, and a thus obtained molded article is called a crosslinked molded article in the present invention.

In the obtained molded article, since the ring-opening bulk polymerization has been almost completely carried out, a remaining cycloolefin monomer is little. Namely, since the reaction rate of the ring-opening bulk polymerization is high, an odor derived from the cycloolefin monomer is weak and deterioration of a work environment of using the molded article can be prevented. The conversion rate of the cycloolefin monomer (a ratio of a bulk polymerized monomer in the whole cycloolefin monomer) in a molded article of the present invention is normally 80% or higher, preferably 90% or higher and more preferably 95% or higher. The conversion rate can be obtained, for example, by analyzing a solution obtained by dissolving the molded article in a solvent by using a gas chromatography. As the solvent, aromatic hydrocarbons such as benzene and toluene; ethers such as diethyl ether and tetrahydrofurane; and halogenated hydrocarbons such as dichloromethane and chloroform may be mentioned.

### <Crosslinked molded article>

A crosslinkable molded article is obtained as a result of almost completely finalizing the ring-opening bulk polymerization, so that the ring-opening bulk polymerization does not furthermore proceed when storing the crosslinkable molded article. Furthermore, even though it contains a crosslinking agent, a crosslinking reaction does not proceed unless heated. Accordingly, the surface hardness of the crosslinkable molded article hardly changes and the preservation stability is excellent. Particularly, a crosslinkable molded article obtained by ring-opening bulk polymerizing a polymerizable composition containing a radical generator as a crosslinking agent and a radical crosslinking retardant is preferable for being excellent in the preservation stability.

By heating a crosslinkable molded article, the crosslinking reaction proceeds and a crosslinked molded article can be obtained. A temperature at the time of crosslinking a crosslinkable molded article is preferably higher than the peak temperature at the time of the ring-opening bulk polymerization by 20°C and is normally 170 to 250°C and preferably 180 to 220°C. Also, the crosslinking reaction time is not particularly limited but is normally several minutes to several hours.

When a crosslinkable molded article is sheet-shaped or film-shaped, it is preferable to conduct crosslinking by heating while keeping it to be a certain shape by stacking the crosslinkable molded articles in accordance with need and hot pressing thereof. A pressure at the time of the hot pressing is normally 0.5 to 20 MPa and preferably 3 to 10 MPa. The hot pressing can be performed by using, for example, a well-known pressing machine having a press frame for plate-shape moldings or a press molding machine, such as a sheet molding compound (SMC) and bulk molding compound (BMC), since these are excellent in productivity.

### <Composite Material and Copper Clad Laminate formed by Crosslinked molded article>

By stacking a crosslinkable molded article and a variety of substrate materials and crosslinking the molded article to obtain a crosslinked molded article, a composite material formed by the substrate material and crosslinked molded article can be obtained. As the substrate material to be used, metal foils such as copper foil, aluminum foil, nickel foil, chrome foil, gold foil and silver foil; a printed wiring board; and films such as a conductive polymer film and other resin films; etc. may be mentioned. Note that when a crosslinkable molded article is produced through the (a) state above, the support body or the other member may be used as they are as the substrate material. By using a copper foil as the support body and the other member, a double-sided copper-clad laminate may be obtained. When crosslinking a crosslinkable molded article, it is preferable to perform hot pressing on stacked crosslinkable molded article and substrate material so as to conduct a highly productive crosslinking reaction and to obtain a crosslinked molded article having a desired shape.

Since a crosslinkable molded article obtained in the present invention has excellent fluidity and adhesiveness, by stacking the same with a substrate material and crosslinking, it is possible to obtain a composite material composed of the substrate material and crosslinked molded article, wherein flatness is excellent, the substrate material and the crosslinked molded article are strongly bonded, and adhesiveness is favorable. When using a metal foil, preferably, a copper foil as the substrate material, a metal-clad laminate, preferably, a copper-clad laminate can be produced as a composite material composed of a crosslinked molded article. A thickness and a surface-roughened condition of a metal foil used here are not particularly limited and may be suitably selected in accordance with the purpose of use. Also, the surface of the metal foil may be treated with a silane coupling agent, thiol-based coupling agent, titanate-based coupling agent or a variety of adhesive agents, etc.; and it is preferable to be treated with a silane coupling agent expressed by the formula (2) or a thiol-based coupling agent expressed by the formula (3).

RSiXYZ (2)

T(SH)ₙ (3)

Here, in the formula (2), "R" indicates a group having either one of a double-bond, mercapto group or amino group at the terminal, "Si" indicates a silicon atom, "X" and "Y" respectively and independently indicate a hydrolyzable group, hydroxyl group or alkyl group. "Z" indicates a hydrolyzable group or hydroxyl group. In the formula (3), "S" indicates a sulfur atom, "H" is a hydrogen atom, "T" is an aromatic ring, aliphatic ring, heterocyclic ring or aliphatic chain, and "n" indicates an integer of two or more.

As specific examples of the silane coupling agent expressed by the formula (2), allyltrimethoxysilane, 3-butenyltrimethoxysilane, p-styryltrimethoxysilane, N-β-(N-(vinylbenzil)aminoethyl)-y-aminopropyltrimethoxysilane and a salt thereof, allyltrichlorosilane, allylmethyldichlorosilane, styryltrichlorosilane, vinyltrimethoxysilane, vinyltriethoxysilane, vinyltriacetoxysilane, vinyltris(2-methoxyethoxy)silane, vinyltrichlorosilane, β-methacryloxyethyltrimethoxysilane, β-methacryloxyethyltriethoxysilane, γ-methacryloxypropyltrimethoxysilane, δ-methacryloxybutyltrimethoxysilane, γ-acryloxypropyltrimethoxysilane, γ-mercaptopropyltrimethoxysilane, γ-mercaptopropylmethyldimethoxysilane, γ-aminopropyltrimethoxysilane, N-phenyl-γ-aminopropyltrimethoxysilane and N-β-(aminoethyl)-γ-aminopropyltrimethoxysilane, etc. may be mentioned. As a thiol coupling agent expressed by the formula (3), for example, 2,4,6-trimercapto-1,3,5-triazole,2,4-dimercapto-6-dibutylamino-1,3,5-triazine and 2,4-dimercapto-6-anilino-1,3,5-triazone, etc. may be mentioned.

A polymer component in the crosslinkable molded article is composed of a thermoplastic resin and, when the crosslinkable molded article is stacked with a metal foil and subjected to hot pressing, the thermoplastic resin once melts to bond with the metal foil and, after that, a crosslinking reaction proceeds and the thermoplastic resin becomes a crosslinked resin. According to the production process of the present invention, a laminate, in which a crosslinked resin and metal foil are firmly bonded, can be obtained. The peel strength of the metal foil of the resulting metal-clad laminate represented by a copper-clad laminate is, for example, when a copper foil is used as the metal foil, preferably 0.8 kN/m or higher and more preferably 1.2 kN/m or higher in a value measured based on JIS C6481.

The process for producing the composite material is suitable for producing a multilayer printed wiring board by using a printed wiring board as the substrate material. The printed wiring board used here is not particularly limited as far as it is a normal printed wiring board for circuits and those widely known can be used. For example, a multilayer printed wiring board can be produced by stacking an outer layer material (single-sided copper-clad laminate, etc.) and an inner layer material (double-sided printed wiring board, etc.) via a prepreg and performing hot pressing. A composite material composed of a crosslinked molded article obtained in this way is suitable as an electric material because a crosslinked molded article having excellent electric insulating property, mechanical strength, heat resistance and dielectric property, etc. is bonded firmly with the substrate material and the adhesiveness is favorable. Also, it is possible to efficiently produce a multilayer printed wiring board, wherein a crosslinked molded article having excellent electric insulating property, mechanical strength and adhesiveness is bonded firmly with the printed wiring board.

### [EXAMPLES]

Below, the present invention will be explained further specificly by examples. The present invention is not limited to these examples. A usage of each component is based on weight unless otherwise mentioned.

### (Example 1)

As a metathesis catalyst, benzylidene(1,3-dimesitylimidazolidine-2-ylidene)(tricyclohexylphosphine)ruthenium dichloride was produced based on the description on page 953 in Vol. 1, 1999 Org. Lett. The metathesis catalyst in an amount of 0.127g and triphenylphosphine (made by Tokyo Chemical Industry Co., Ltd.) in an amount of 0.197g were put in a round-bottomed flask, vacuum deaeration and nitrogen filling are repeated and, finally, the flask was nitrogen sealed. Toluene (made by Wako Pure Chemical Industries, Ltd.) in an amount of 2.68ml were added to dissolve the components while flowing the nitrogen, and a toluene solution of the metathesis catalyst was prepared.

A mixture of tetracyclododecene (TCD) and norbornene (NB) (obtained by adding 0.28 part of 2,6-dit-butylhydroxy toluene as an antioxidant to TCD/NB = 80 parts / 20 parts in the weight ratio) in an amount of 50.14g and silica (made by "Admafine" Admatechs Co., Ltd., Product Name of SO-E1, p-styryltrimethoxysilane (St-Si) treated substance having an average particle diameter of 0.25µm) as a filler in an amount of 50g (100 parts by weight per 100 parts by weight of a norbornene monomer) were mixed and agitated by using an agitator (planetary agitator made by THINKY Japan) for 5 minutes. Allyl methacrylate (made by Tokyo Chemical Co., Ltd) as a chain transfer agent in an amount of 0.58ml and di-t-butyl peroxide (product name of Kayabutyl D made by Kayaku Akzo Co., Ltd.) as a crosslinking agent of an organic peroxide in an amount of 0.29ml were added, the above explained solution of the metathesis catalyst in an amount of 0.08ml was added and agitated so as to obtain a polymerizable composition.

A glass yarn cloth (having a bulk density of 0.98g/cm³, product name of GC2112MS made by Asahi Schewer Co., Ltd.) cut into 21cm square was placed on a polyethylene naphthalate (PEN) film (having a thickness of 75µm made by Teijin DuPont Films Japan Limited) as a support body. One forth of the above polymerizable composition was poured at the center portion on the lower side of the glass yarn cloth. Another one forth is poured at the center portion on the upper side of the glass yarn cloth and covered with another PEN film. A paint apply roller was used to spread the polymerizable composition to be thin and uniform allover visually. At this time, viscosity of the polymerizable composition was low and it was possible to spread easily and uniformly, so that the moldability was preferable. After placing the obtained laminates on a hot plate adjusted to 155°C for one minute, the upper and lower PEN films were peeled off, and a plate-shaped molded article (crosslinkable molded article) was produced. Results of observing the obtained molded article with eyes and under a microscope are shown in Table 1.

Three crosslinkable molded articles as above were produced and cut to obtain 10 crosslinkable molded articles having a size of 10cm square. These were stacked and sandwiched between the above-explained two PEN films and pressed and heated at the same time by hot pressing while keeping a plate shape. A condition of the hot pressing was a pressure of 5 MPa, a temperature of 200°C and a time for 15 minutes. The PEN films were peeled off after the hot pressing and a plate-shaped crosslinked molded article was obtained. A temperature change and a size change were measured, and a coefficient of linear expansion α_{Z} in the Z direction (the thickness direction) was measured. The measurement results are shown in Table 1.

### (Example 2)

Except for changing the glass yarn cloth to GC1037 (the bulk density is 0.91g/cm³) made by Asahi Schewer Co., Ltd., a crosslinkable molded article and a crosslinked molded article were obtained in the same way as in the Example 1. The test results are shown together in Table 1.

### (Example 3)

Except for changing the glass yarn cloth to the one having a product name of GC1080 (the bulk density is 1.06g/cm³), a crosslinkable molded article and a crosslinked molded article were obtained in the same way as in the Example 1. The results are shown together in Table 1.

### (Example 4)

Except for changing a blending quantity of the filler to 15g (30 parts by weight per 100 parts by weight of a norbornene monomer), a crosslinkable molded article and a crosslinked molded article were obtained in the same way as in the Example 1. The results are shown together in Table 1.

### (Example 5)

Except for changing p-styryltrimethoxysilane (St-Si) to hexyltrimethoxysilane (Hex-Si) in the surface treatment of the filler, a crosslinkable molded article and a crosslinked molded article were obtained in the same way as in the Example 1. The results are shown together in Table 1.

### (Example 6)

Except for changing the particle diameter of the filler from 0.25µm (SO-E1) to 0.5µm (SO-E2), a crosslinkable molded article and a crosslinked molded article were obtained in the same way as in the Example 1. The results are shown together in Table 1.

### (Example 7)

Except for not blending a filler, a crosslinkable molded article and a crosslinked molded article were obtained in the same way as in the Example 1. The results are shown together in Table 1.

### (Comparative Example 1)

Except for changing the glass yarn cloth to the one having a product name of GC2116 (the bulk density is 1.15g/cm³) made by Asahi Schewer Co., Ltd., a crosslinkable molded article and a crosslinked molded article were obtained in the same way as in the Example 1. The results are shown together in Table 1.

### (Comparative Example 2)

Except for changing the blending quantity of the filler from 100 parts to 30 parts, a crosslinkable molded article and a crosslinked molded article were obtained in the same way as in the Comparative Example 1. The results are shown together in Table 1.

### (Comparative Example 3)

Except for not performing any surface treatment on the filler, a crosslinkable molded article and a crosslinked molded article were obtained in the same way as in the Comparative Example 2. The results are shown together in Table 1.

### (Comparative Example 4)

Other than not blending any filler, a crosslinkable molded article and a crosslinked molded article were obtained in the same way as in the Comparative Example 1. The results are shown together in Table 1.

[Table 1]

**Table 1: Measurement Results**

| | Yarn cloth | | | Filler | | | | Impregnation | α_{z} |
|---|---|---|---|---|---|---|---|---|---|
| | No. | bulk density | thickness | No. | Particle diameter | surface treatment | Amount (parts) | void/bubble | |
| Ex. 1 | GC2112MS | 0. 98g/cm³ | 69 µm | S0-E1 | 0. 25 µm | St-Si | 100 | A | A |
| Ex. 2 | GC1037MS | 0. 91g/cm³ | 26 µm | S0-E1 | 0. 25 µm | St-Si | 100 | A | A |
| Ex. 3 | GC1080MS | 1. 06g/cm³ | 45 µm | S0-E1 | 0. 25 µm | St-Si | 100 | A | B |
| Ex. 4 | GC2112MS | 0. 98g/cm³ | 69 µm | S0-E1 | 0. 25 µm | St-Si | 30 | A | C |
| Ex. 5 | GC2112MS | 0. 98g/cm³ | 69 µm | S0-E1 | 0. 25 µm | Hex-Si | 100 | B | B |
| Ex. 6 | GC2112MS | 0. 98g/cm³ | 69 µm | S0-E2 | 0. 5 µm | St-Si | 100 | A | B |
| Ex. 7 | GC2112MS | 0. 98g/cm³ | 69 µm | - | - | - | - | A | D |
| Comp.Ex. 1 | GC2116MS | 1. 15g/cm³ | 91 µm | S0-E1 | 0. 25 µm | St-Si | 100 | D | D |
| Comp.Ex. 2 | GC2116MS | 1. 15g/cm³ | 91 µm | S0-E1 | 0. 25 µm | St-Si | 30 | C | E |
| Comp.Ex. 3 | GC2116MS | 1. 15g/cm³ | 91 µm | S0-E1 | 0.25 µm | - | 30 | D | E |
| Comp.Ex. 3 | GC2116MS | 1. 15g/cm³ | 91 µm | - | - | - | - | A | D |

In Table 1, the "impregnation" was evaluated based on the standards below by observing inside of the obtained crosslinked molded article with using a microscope.
A: no bubble is observed in observation with using microscope
B: few bubbles are observed in observation with using microscope
C: bubbles are observed in observation with using microscope
D: many bubbles are observed in observation with using microscope

In Table 1, "α_{z}" indicates a linear expansion of the obtained crosslinked molded article in the Z direction (thickness direction) and was evaluated based on the standards below.
A: α_{z} < 45ppm/°C
B: 45ppm/°C ≤ α_{z} < 50ppm/°C
C: 50ppm/°C ≤ α_{z} < 60ppm/°C
D: 60ppm/°C ≤ α_{z} < 70ppm/°C
E: 70ppm/°C ≤ α_{z}

Table 1 tells that the polymerizable composition of the present invention has preferable impregnation and that the resulting crosslinked molded article is preferable because there are few bubbles remaining therein and a coefficient of the linear expansion α_{z} in the thickness direction is small.

### Industrial Applicability

The present invention provides a crosslinkable molded article and a crosslinked molded article free from molding failures, wherein their coefficient of thermal expansion is sufficiently low, their dimensional accuracy is high and a polymerizable composition is sufficiently filled in a fibrous material; and a production method thereof. These crosslinkable molded article and crosslinked molded article can be used as a variety of members in many industrial fields, such as electronic devices, electric equipments, automotive parts, architecture and civil engineering works. Particularly, a composite material composed of the crosslinked molded article is preferably used as electronic devices, such as a copper-clad laminate.

## Claims

1. A process for producing a molded article comprising the step of performing ring-opening bulk polymerization of a polymerizable composition comprising a cycloolefin monomer and a metathesis catalyst in the presence of a glass yarn cloth having a bulk density of 0.50 to 1.10 g/cm³.

2. The process for producing a molded article as set forth in claim 1, wherein the polymerizable composition further comprises a filler.

3. The process for producing a molded article as set forth in claim 1 or 2, wherein the polymerizable composition further comprises a crosslinking agent.

4. The process for producing a molded article as set forth in any one of claims 1 to 3, wherein the ring-opening bulk polymerization is performed in a state where the glass yarn cloth is arranged on a support body and the polymerizable composition exists inside and both outer surfaces of the glass yarn cloth.

5. The process for producing a molded article as set forth in any one of claims 1 to 3, wherein the ring-opening bulk polymerization is performed in a state where the glass yarn cloth is arranged in a mold, and the polymerizable composition exists inside the glass yarn cloth and between the glass yarn cloth and the mold.

6. A molded article, obtainable by
arranging a glass yarn cloth having a bulk density of 0.50 to 1.10 g/cm³ on a support body, and
performing ring-opening bulk polymerization of a polymerizable composition in a state where the polymerizable composition comprising a cycloolefin monomer, a metathesis catalyst and a crosslinking agent exists inside and both outer surfaces of the glass yarn cloth.

7. A molded article, obtainable by
arranging a glass yarn cloth having a bulk density of 0.50 to 1.10 g/cm³ on a support body, and
performing ring-opening bulk polymerization of a polymerizable composition in a state where the polymerizable composition comprising a cycloolefin monomer, a metathesis catalyst, a crosslinking agent and a filler exists inside and both outer surfaces of the glass yarn cloth.

8. A crosslinked molded article obtainable by heating the molded article as set forth in claim 6 or 7 to a higher temperature than a peak temperature of the ring-opening bulk polymerization and crosslinking the same.

9. A composite material comprising a substrate material and a crosslinked molded article, obtainable by stacking the molded article as set forth in claim 6 or 7 on the substrate material to obtain a laminate, heating the laminate to a higher temperature than a peak temperature of the ring-opening bulk polymerization and crosslinking the same.

10. A copper-clad laminate obtainable by stacking the molded article as set forth in claim 6 or 7 and a copper foil, heating the molded article to a higher temperature than a peak temperature of the ring-opening bulk polymerization and crosslinking the same.
